(19)

Europäisches
Patentamt
European
Patent Office
Office européen
des brevets

(11) **EP 4 707 358 A1**

(12) **EUROPEAN PATENT APPLICATION**

(43) Date of publication:
**11.03.2026   Bulletin 2026/11**

(21) Application number: **25199813.4**

(22) Date of filing: **03.09.2025**

(51) International Patent Classification (IPC):
***C09K 11/77*** *(2006.01)*       ***H10H 20/851*** *(2025.01)*

(52) Cooperative Patent Classification (CPC):
**C09K 11/77348; H10H 20/8512;** C09K 11/77342;
C09K 11/7737; C09K 11/7774; H10H 20/8502;
H10H 20/8513; H10H 20/857

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:   **06.09.2024   JP 2024154149**

(71) Applicant: **NICHIA CORPORATION**
**Anan-shi,**
**Tokushima 774-8601 (JP)**

(72) Inventors:
• **SUZUKI, Shigeyuki**
  **Anan-shi, Tokushima 774-8601 (JP)**
• **SAKAMOTO, Masafumi**
  **Anan-shi, Tokushima 774-8601 (JP)**
• **SHINOHARA, Takayuki**
  **Anan-shi, Tokushima 774-8601 (JP)**

(74) Representative: **Vossius & Partner**
**Patentanwälte Rechtsanwälte mbB**
**Siebertstrasse 3**
**81675 München (DE)**

(54) **NITRIDE PHOSPHOR AND LIGHT EMITTING DEVICE**

(57)     A nitride phosphor, having a composition that contains Eu, Si, Al, N, and a Group 2 element containing at least one selected from the group consisting of Mg, Ca, Sr, and Ba. With respect to a molar content of Al in the composition, a ratio of a total molar content of the Group 2 element and Eu is in a range of 0.8 to 1.1, a ratio of a molar content of Eu is in a range of 0.002 to 0.08, a ratio of a molar content of Si is in a range of 0.8 to 1.2, and a ratio of a total molar content of Si and Al is in a range of 1.8 to 2.2. The nitride phosphor has an average value of an aspect ratio, which is a minor-axis-to-major-axis ratio, in a range of 0.72 to 0.77, and an average circularity in a range of 0.82 to 0.92.

EP 4 707 358 A1

**Description**

CROSS-REFERENCE TO RELATED APPLICATIONS

This application claims priority to Japanese Patent Application No. 2024-154149, filed on September 6, 2024, the disclosure of which is hereby incorporated by reference in its entirety.

TECHNICAL FIELD

The present disclosure relates to a nitride phosphor and a light emitting device.

BACKGROUND

Light emitting devices using a combination of a light emitting diode (hereinafter, referred to as "LED") and a phosphor have been applied to lighting devices, backlights of liquid crystal displays, and the like. Examples of the phosphor used in such light emitting devices include nitride phosphors containing nitrogen in their compositions and, for example, red phosphors that contain $CaAlSiN_3$ as a host crystal and are activated with $Eu^{2+}$, hereinafter, also referred to as "CASN phosphors", and $(Sr,Ca)AlSiN_3$:Eu obtained by partially substituting Ca of a CASN phosphor with Sr, hereinafter, also referred to as "SCASN phosphors", are known. CASN phosphors and SCASN phosphors have an emission peak wavelength in a wide range of 600 nm to 670 nm, depending on their compositions.

In relation to a nitride phosphor, WO 2023/037727 discloses a fluorescent powder having an average circularity and a standard deviation of the circularity in predetermined ranges.

SUMMARY

An object of one aspect of the present disclosure is to provide: a nitride phosphor that can provide a higher luminous flux when constituting a light emitting device; and a light emitting device including the same.

A first aspect is a nitride phosphor having a composition that includes Eu, Si, Al, N, and a Group 2 element containing at least one selected from the group consisting of Mg, Ca, Sr, and Ba. In this nitride phosphor, a ratio of a total molar content of the Group 2 element and Eu is in a range of 0.8 to 1.1, a ratio of a molar content of Eu is in a range of 0.002 to 0.08, a ratio of a molar content of Si is in a range of 0.8 to 1.2, and a ratio of a total molar content of Si and Al is in a range of 1.8 to 2.2, with respect to a molar content of Al in the composition. Further, the nitride phosphor has an average value of an aspect ratio, which is a minor-axis-to-major-axis ratio, in a range of 0.72 to 0.77, and an average circularity in a range of 0.82 to 0.92.

A second aspect is a light emitting device including: a fluorescent member containing the nitride phosphor of the first aspect; and a light emitting element having an emission peak wavelength in a range of 365 nm to 500 nm.

According to an aspect of the present disclosure, the following can be provided: a nitride phosphor that can provide a higher luminous flux when constituting a light emitting device; and a light emitting device including the same.

BRIEF DESCRIPTION OF THE DRAWINGS

FIG. 1 shows an example of a scanning electron microscope (SEM) image of the nitride phosphor according to Comparative Example 1.
FIG. 2 shows an example of an SEM image of the nitride phosphor according to Example 1.
FIG. 3 shows an example of an SEM image of the nitride phosphor according to Comparative Example 2.
FIG. 4 shows an example of an SEM image of the nitride phosphor according to Example 2.
FIG. 5 shows an example of an SEM image of the nitride phosphor according to Example 3.
FIG. 6 shows an example of an SEM image of the nitride phosphor according to Example 4.
FIG. 7 shows an example of an SEM image of the nitride phosphor according to Comparative Example 3.
FIG. 8 shows an example of an SEM image of the nitride phosphor according to Example 5.
FIG. 9 shows an example of an SEM image of the nitride phosphor according to Example 6.
FIG. 10 shows an example of an SEM image of the nitride phosphor according to Example 7.
FIG. 11 shows an example of an SEM image of the nitride phosphor according to Example 8.
FIG. 12 shows an example of an SEM image of the nitride phosphor according to Comparative Example 4.
FIG. 13 shows an example of the SEM image of the nitride phosphor according to Example 9.
FIG. 14 is a schematic cross-sectional view illustrating an example of a light emitting device.

DETAILED DESCRIPTION

The term "step" used herein encompasses not only a discrete step but also a step that cannot be clearly distinguished from other steps, as long as the intended purpose of the step is achieved. When there are plural substances that correspond to a component of a composition, an indicated amount of the component contained in the composition means, unless otherwise specified, a total amount of the plural substances existing in the composition. Further, as an upper limit and a lower limit of a numerical range described in the present specification, values exemplified for the numerical range can be arbitrarily selected and combined. In the present specification, plural elements that are listed separately with commas (,) in a formula representing the composition of a phosphor, a light-emitting material, or a compound mean that at least one of the plural elements is included in the composition. Further, in a formula representing the composition of a phosphor, the part preceding a colon (:) represents a host crystal, and the part following the colon (:) represents an activation element. In the present specification, the relationships between color names and chromaticity coordinates, the relationships between wavelength ranges of light and color names of monochromatic light, and the like conform to JIS Z8110. A "half-value width" of a phosphor means, in an emission spectrum of the phosphor, a wavelength width at which the light emission intensity is 50% relative to the maximum light emission intensity (full-width at half maximum; FWHM). Embodiments of the present invention will now be described in detail. It is noted here, however, that the below-described embodiments are merely examples of a nitride phosphor and a light emitting device that embody the technical ideas of the present invention, and the present invention is not limited to the below-described nitride phosphor and light emitting device.

Nitride Phosphor

The nitride phosphor has a composition that includes Eu, Si, Al, N, and a Group 2 element containing at least one selected from the group consisting of Mg, Ca, Sr, and Ba. In the composition of the nitride phosphor, a ratio of a total molar content of the Group 2 element and Eu may be, for example, in a range of 0.8 to 1.1 with respect to a molar content of Al; a ratio of a molar content of Eu may be, for example, in a range of 0.002 to 0.08 with respect to the molar content of Al; a ratio of a molar content of Si may be, for example, in a range of 0.8 to 1.2 with respect to the molar content of Al; and a ratio of a total molar content of Si and Al may be, for example, in a range of 1.8 to 2.2 with respect to the molar content of Al. The nitride phosphor may have an average value of an aspect ratio, which is a minor-axis-to-major-axis ratio, in a range of 0.72 to 0.77. Further, the nitride phosphor may have an average circularity in a range of 0.82 to 0.92.

The nitride phosphor has a specific composition, and its particles have a shape defined by a specific range of aspect ratio and a specific range of average circularity; therefore, the nitride phosphor may achieve a high luminous flux when constituting a light emitting device. This is believed to be because, for example, the nitride phosphor is uniformly dispersed in a resin of a wavelength conversion member constituting the light emitting device and thereby evenly arranged in the wavelength conversion member, as a result of which the emission loss caused by reabsorption of light emitted from a light emitting element and light emitted from the nitride phosphor and other phosphors by the nitride phosphor can be reduced.

The nitride phosphor has a composition that includes a Group 2 element containing at least one selected from the group consisting of Mg, Ca, Sr, and Ba. The Group 2 element included in the composition of the nitride phosphor may contain at least one of Ca or Sr, or may contain at least Ca. A ratio of a total molar content of Ca and Sr with respect to a total molar content of the Group 2 element included in the composition of the nitride phosphor may be, for example, 0.8 or higher, preferably 0.9 or higher, and the Group 2 element may substantially consist of Ca and Sr. The term "substantially" used herein means not to exclude those Group 2 elements other than Ca and Sr that are unavoidably incorporated. A ratio of the molar content of Group 2 elements other than Ca and Sr with respect to a total molar content of Ca and Sr may be, for example, 0.1 or lower, preferably 0.08 or lower.

In the composition of the nitride phosphor, a ratio of a total molar content of the Group 2 element and Eu with respect to the molar content of Al may be preferably 0.94 to 1.1, or 0.95 to 1.05. In the composition of the nitride phosphor, a ratio of the molar content of Eu with respect to the molar content of Al may be preferably in a range of 0.002 to 0.08, or 0.004 to 0.07. In the composition of the nitride phosphor, a ratio of the molar content of Si with respect to the molar content of Al may be preferably in a range of 0.8 to 1.2, or 0.9 to 1.1. In the composition of the nitride phosphor, a ratio of a total molar content of Si and Al with respect to the molar content of Al may be preferably in a range of 1.8 to 2.2, or 1.9 to 2.1. The composition of the nitride phosphor may be determined by X-ray fluorescence (XRF) analysis.

The nitride phosphor may have a composition represented by, for example, the following Formula (I):

$$M^a_sSr_tEu_uSi_vAl_wN_x \qquad (I)$$

In Formula (I), $M^a$ represents a Group 2 element containing at least one selected from the group consisting of Mg, Ca, and Ba, and may contain preferably at least Ca; s, t, u, v, w, and x may satisfy $0 \leq s < 1$, $0 \leq t < 1$, $0.002 \leq u \leq 0.08$, $0.8 \leq s +$

t + u ≤ 1.1, 0.8 ≤ v ≤ 1.2, 0.8 ≤ w ≤ 1.2, 1.8 ≤ v + w ≤ 2.2, and 2.5 ≤ x ≤ 3.2; and s, t, and u may satisfy 0.94 ≤ s + t + u ≤ 1.10.

The nitride phosphor may have an average value of an aspect ratio, also referred to "average aspect ratio", which is a minor axis-to-major axis ratio, of 0.72 to 0.77, preferably 0.73 or higher, but 0.76 or lower, or 0.75 or lower. The average aspect ratio of the nitride phosphor is an arithmetic mean value of the minor axis-to-major axis ratio measured for arbitrarily selected 10 nitride phosphor particles. These nitride phosphor particles are selected from an image captured by observation under an optical microscope, excluding those phosphor particles recognized in the image which overlap each other, whose overall shapes are not visible, or which are obviously fine. The major axis is a maximum value of the length of a line segment connecting two points on the outer edge of a particle of the nitride phosphor, and the minor axis is a maximum value of the length of a line segment that is a straight line perpendicular to the major axis and connects two intersections of the outer edges of the particle. Specifically, the aspect ratio of the nitride phosphor is measured using a particle image analyzer MORPHOLOGI G3S (manufactured by Malvern Panalytical Ltd.). The average aspect ratio of the nitride phosphor is evaluated as a numerical value rounded off to two decimal places.

The nitride phosphor may have an average circularity of 0.82 to 0.92, preferably 0.85 or more, or 0.87 or more, but 0.91 or less, or 0.90 or less. The average circularity of the nitride phosphor is an arithmetic mean value of the particle circularity measured for arbitrarily selected 10 nitride phosphor particles. These nitride phosphor particles are selected from an image captured by observation under an optical microscope, excluding those phosphor particles recognized in the image which overlap each other, whose overall shapes are not visible, or which are obviously fine. The circularity of each nitride phosphor particle is calculated by the equation below from the projected area S and the circumferential length L of the particle. Specifically, the circularity of each nitride phosphor particle is measured using a particle image analyzer MORPHOLOGI G3S (manufactured by Malvern Panalytical Ltd.). The average circularity of the nitride phosphor is evaluated as a numerical value rounded off to two decimal places.

$$Circularity = 4\pi S/L^2$$

The nitride phosphor may have a volume-average particle size (Dm) of, for example, 20 $\mu$m to 40 $\mu$m and, from the standpoint of light emission efficiency, the volume-average particle size (Dm) may be preferably 23 $\mu$m or larger, or 25 $\mu$m or larger, but 36 $\mu$m or smaller. The larger the volume-average particle size of the nitride phosphor, the higher tend to be the excitation light absorption rate and the light emission efficiency. In this manner, applying the nitride phosphor having good optical characteristics to the below-described light emitting device can further improve the light emission efficiency of the light emitting device. Moreover, the nitride phosphor preferably contains nitride phosphor particles having the above-described volume-average particle size with a high frequency. In other words, the particle size distribution is preferably in a narrow range. By using a nitride phosphor having a small variation in its particle size distribution, color unevenness is further inhibited, so that a light emitting device having a more favorable color may be obtained. The logarithmic standard deviation ($\sigma$log) of the volume-based particle size distribution of the nitride phosphor may be, for example, 0.25 or more but less than 0.38, preferably 0.37 or less, or 0.36 or less, but 0.26 or more.

The volume-average particle size of the nitride phosphor is determined as a particle size corresponding to a cumulative volume of 50% from the small diameter side in a volume-based particle size distribution curve obtained by measuring the particle size distribution by a laser diffraction-scattering method. Specifically, the volume-average particle size of the nitride phosphor is a value obtained by measuring the volume-based particle size distribution using a laser diffraction-type particle size distribution analyzer (e.g., product name: MASTER SIZER 3000, manufactured by Malvern Panalytical, Ltd.).

The nitride phosphor may have an average particle size (D) determined by an air permeability method of, for example, 20 $\mu$m to 30 $\mu$m and, from the standpoint of light emission efficiency, the average particle size (D) may be preferably 21 $\mu$m or more, or 22 $\mu$m or more, but 25 $\mu$m or less. The average particle size (D) determined by an air permeability method may be an F.S.S.S.No. (Fisher Sub Sieve Sizer's No.), and is measured using, for example, Fisher Sub-Sieve Sizer Model 95 manufactured by Thermo Fisher Scientific, Inc.

In the nitride phosphor, from the standpoint of light emission efficiency, a ratio (D/Dm) of the average particle size (D) determined by an air permeability method with respect to the volume-average particle size (Dm) may be, for example, 0.75 to 0.92, preferably 0.76 or higher, or 0.77 or higher, but 0.91 or lower, or 0.90 or lower.

The nitride phosphor may have an emission peak wavelength in a range of, for example, 600 nm to 675 nm. The emission peak wavelength of the nitride phosphor may be preferably 605 nm or more, or 610 nm or more, but preferably 660 nm or less, or 640 nm or less. The half-value width of the emission peak of the nitride phosphor may be, for example, 70 nm to 78 nm, preferably 76 nm or less, or 74 nm or less. When the half-value width of the emission peak is in this range, the luminous flux of a light emitting device tends to be further improved.

Method of Producing Nitride Phosphor

A method of producing a nitride phosphor may include heat-treating a raw material mixture, which contains a Group 2 element source, an europium source, a silicon source, and an aluminum source, at a temperature of 1,800°C to 2,100°C in a nitrogen-containing atmosphere to obtain a heat-treated product. This heat-treated product may contain a nitride phosphor, and the nitride phosphor to be produced may be the above-described nitride phosphor.

The Group 2 element in the Group 2 element source contained in the raw material mixture is at least one selected from the group consisting of Mg, Ca, Sr, and Ba, and may contain at least one of Ca or Sr, or may contain at least Ca.

The Group 2 element source may be, for example, a Group 2 element-containing metal compound, a simple metal of a Group 2 element, or a Group 2 element-containing alloy. Examples of the Group 2 element-containing metal compound include Group 2 element-containing hydrides, oxides, hydroxides, nitrides, oxynitrides, chlorides, amide compounds, and imide compounds. The Group 2 element-containing metal compound is preferably a hydride, a nitride, an amide compound, an imide compound, or the like. The Group 2 element source may also contain Li, Na, K, B, Al, or the like.

The Group 2 element source may contain at least a Group 2 element-containing metal compound, and the Group 2 element-containing metal compound may contain at least one Group 2 element-containing hydride (hereinafter, also referred to as "Group 2 element hydride"), and at least one compound selected from the group consisting of Group 2 element-containing amide compound and imide compound. By incorporating a Group 2 element-containing hydride into the Group 2 element source, a nitride phosphor that has a crystal structure with few defects and whose particle size is relatively large because of facilitated crystal growth may be obtained. Further, when the raw material mixture is heat-treated, hydrogen contained in the Group 2 element hydride reacts with oxygen in the heat treatment atmosphere to form water, and is likely to be released out of the reaction system. Therefore, oxygen and the like are hardly incorporated into the composition of the resulting nitride phosphor, so that a nitride phosphor having a low content of elements other than those in the intended composition, such as oxygen that may cause degradation of the emission characteristics, may be obtained.

The Group 2 element-containing amide compound and imide compound (hereinafter, also referred to as "amide compound and imide compound of Group 2 element") are compounds having a higher nitrogen mass ratio in one molecule than a Group 2 element-containing nitride. By using at least one of a Group 2 element-containing amide compound or a Group 2 element-containing imide compound as the Group 2 element source, not only the Group 2 element is supplied but also nitrogen may be sufficiently supplied such that the resulting composition is close to a theoretical composition, and a nitride phosphor that has a crystal structure with few defects and whose particle size is relatively large because of facilitated crystal growth may be obtained.

Specific examples of the Group 2 element hydride include $MgH_2$, $CaH_2$, $SrH_2$, $BaH_2$, $(Sr,Ca)H_2$, and $(Sr,Ca,Eu)H_2$, and the Group 2 element source may contain at least one selected from the group consisting of these hydrides. Specific examples of the amide compound and imide compound of Group 2 element include $Sr(NH_2)_2$, $Ca(NH_2)_2$, $(Sr,Ca)(NH_2)_2$, $(Sr,Ca,Eu)(NH_2)_2$, SrNH, CaNH, $(Sr,Ca)NH$, and $(Sr,Ca,Eu)NH$, and the Group 2 element source may contain at least one selected from the group consisting of these compounds.

In the Group 2 element source, a mass-based content ratio of the Group 2 element hydride with respect to a total amount of the Group 2 element hydride and the amide compound and imide compound of Group 2 element may be, for example, in a range of 20% by mass to 80% by mass, preferably in a range of 25% by mass to 75% by mass. When the content ratio of the hydride is in this range, the Group 2 element and nitrogen element may be sufficiently supplied as elements that constitute a crystal structure, so that a nitride phosphor which has a crystal structure with reduced defects and exhibits an good light emission intensity, and whose particle size is relatively large because of facilitated crystal growth, may be obtained.

As the Group 2 element-containing hydride and the amide compound and imide compound, those acquired through purchasing or otherwise obtaining or the like, or produced may be used. The hydride may be produced by, for example, heat-treating a Group 2 simple metal in a hydrogen-containing inert atmosphere. The amide compound and imide compound may be produced by heat-treating a Group 2 simple metal in an atmosphere containing nitrogen and hydrogen. From the standpoint of reducing impurities contained in the resulting nitride phosphor, the purity of the Group 2 element-containing hydride and that of the amide compound and imide compound may be, for example, 95% by mass or higher, preferably 98% by mass or higher, 99% by mass or higher, or 99.5% by mass or higher.

The Group 2 element source may also contain Group 2 element-containing other compound and the like, than the Group 2 element-containing hydride, and the amide compound and imide compound. Examples of the Group 2 element-containing other compound include oxides, hydroxides, nitrides, oxynitrides, and chlorides, and the Group 2 element source may contain at least a nitride. In the Group 2 element source, the content ratio of the compound other than the hydride and the amide compound and imide compound may be, for example, 10% by mass or less, preferably 5% by mass or less, 3% by mass or less, 2% by mass or less, or 1% by mass or less.

The europium source contained in the raw material mixture may be, for example, an europium compound, an europium simple metal, or an europium alloy. Examples of the europium compound include europium-containing oxides, hydroxides, nitrides, oxynitrides, fluorides, and chlorides. Specific examples of the europium compound include europium

oxide ($Eu_2O_3$), europium nitride (EuN), and europium fluoride ($EuF_3$), and the raw material mixture may contain at least one selected from the group consisting of these europium compounds. Europium nitride (EuN) consists of elements of the intended phosphor composition and, therefore, may more effectively inhibit the contamination with impurities. Further, europium oxide ($Eu_2O_3$) and europium fluoride ($EuF_3$) may be preferably used because they may function as a flux. These europium compounds may be used singly, or in combination of two or more thereof.

An europium compound to be used may be acquired through purchasing or otherwise obtaining or the like, or a desired europium compound may be produced. For example, europium nitride may be obtained by pulverizing europium used as a raw material in an inert gas atmosphere, and subsequently heat-treating and thereby nitriding the thus obtained powder in a nitrogen atmosphere or an ammonia atmosphere. The pulverized europium may have an average particle size of, for example, 0.1 $\mu$m to 10 $\mu$m. Further, the heat treatment temperature may be, for example, 600°C to 1,200°C, and the heat treatment time may be, for example, 1 hour to 20 hours. The resulting europium nitride may be subjected to, for example, a pulverization treatment in an inert gas atmosphere.

The raw material mixture may be a mixture in which the europium source is at least partially substituted with, for example, a metal compound, simple metal, or alloy or the like of a rare earth element such as scandium (Sc), yttrium (Y), lanthanum (La), cerium (Ce), praseodymium (Pr), neodymium (Nd), samarium (Sm), gadolinium (Gd), terbium (Tb), dysprosium (Dy), holmium (Ho), erbium (Er), thulium (Tm), ytterbium (Yb), or lutetium (Lu). Examples of the metal compound include oxides, hydroxides, nitrides, oxynitrides, fluorides, and chlorides.

The europium source (e.g., an europium compound) may have a purity of, for example, 95% by mass or higher, preferably 99.5% by mass or higher. By controlling the purity to be equal to or higher than the predetermined value, the adverse effects caused by the presence of an impurity are reduced, so that the light emission intensity of the resulting nitride phosphor may be further improved.

The silicon source contained in the raw material mixture may be, for example, a silicon compound, simple silicon, or a silicon alloy. Examples of the silicon compound include silicon-containing oxides, hydroxides, nitrides, oxynitrides, fluorides, and chlorides. Specific examples of the silicon compound include silicon oxide, silicon nitride, silicon oxynitride, and silicates. It is preferred to use at least one selected from the group consisting of these silicon compounds, and it is more preferred to use silicon nitride. Silicon nitride consists of elements of the intended phosphor composition and, therefore, may more effectively inhibit the contamination with impurities. As compared to, for example, a silicon compound containing oxygen and/or hydrogen, silicon nitride may reduce the effects of these elements, and does not require a nitriding reaction unlike a simple metal. These silicon compounds may be used singly, or in combination of two or more thereof.

A silicon compound to be used may be acquired through purchasing or otherwise obtaining or the like, or a desired silicon compound may be produced. For example, silicon nitride may be obtained by pulverizing silicon used as a raw material in an inert gas atmosphere, and subsequently heat-treating and thereby nitriding the thus obtained powder in a nitrogen atmosphere. The heat treatment temperature may be, for example, 800°C to 2,000°C, and the heat treatment time may be, for example, 1 hour to 20 hours. The resulting silicon nitride may be subjected to, for example, a pulverization treatment in an inert gas atmosphere.

The raw material mixture may be a mixture in which the silicon source is partially substituted with, for example, a metal compound, simple metal, or alloy or the like of a Group 4 or 14 element such as germanium (Ge), tin (Sn), titanium (Ti), zirconium (Zr), or hafnium (Hf). Examples of the metal compound include oxides, hydroxides, nitrides, oxynitrides, fluorides, and chlorides.

The silicon source (e.g., a silicon compound) may have a purity of, for example, 95% by mass or higher, preferably 99% by mass or higher. By controlling the purity to be equal to or higher than the predetermined value, the effects of impurities are reduced, so that the light emission intensity of the resulting nitride phosphor may be further improved.

The aluminum source contained in the raw material mixture may be, for example, an aluminum compound, an aluminum simple metal, or an aluminum alloy. Examples of the aluminum compound include aluminum-containing oxides, hydroxides, nitrides, oxynitrides, fluorides, and chlorides. Specific examples of the aluminum compound include aluminum nitride (AlN), aluminum oxide ($Al_2O_3$), and aluminum hydroxide ($Al(OH)_3$). It is preferred to use at least one selected from the group consisting of these aluminum compounds, and it is more preferred to use aluminum nitride. Aluminum nitride consists of elements of the intended phosphor composition and, therefore, may more effectively inhibit the contamination with impurities. As compared to, for example, an aluminum compound containing oxygen and/or hydrogen, aluminum nitride may reduce the effects of these elements, and does not require a nitriding reaction unlike a simple metal. These aluminum compounds may be used singly, or in combination of two or more thereof.

An aluminum compound to be used may be acquired through purchasing or otherwise obtaining or the like, or a desired aluminum compound may be produced. For example, aluminum nitride may be produced by an aluminum direct nitriding method or the like.

The raw material mixture may be a mixture in which the aluminum source is at least partially substituted with, for example, a metal compound, simple metal, or alloy of a Group 13 element such as gallium (Ga) or indium (In), a Group 5 element such as vanadium (V), a Group 6 element such as chromium (Cr), or a Group 9 element such as cobalt (Co). Examples of the metal compound include oxides, hydroxides, nitrides, oxynitrides, fluorides, and chlorides.

The aluminum source (e.g., an aluminum compound) may have a purity of, for example, 95% by mass or higher, preferably 99% by mass or higher. By controlling the purity to be equal to or higher than the predetermined value, the effects of impurities are reduced, so that the light emission intensity of the resulting phosphor may be further improved.

The raw material mixture may further contain at least one metal fluoride. When the raw material mixture further contains at least one metal fluoride, a nitride phosphor having a higher light emission intensity tends to be obtained.

The metal fluoride may preferably contain at least one selected from the group consisting of a Group 2 element-containing metal fluoride, a rare earth element-containing metal fluoride, a Group 4 or 14 element-containing metal fluoride, and a Group 13 element-containing metal fluoride.

The Group 2 element in the metal fluoride may contain at least one selected from the group consisting of Mg, Ca, Sr, and Ba, preferably at least one of Sr or Ca, more preferably at least Ca. When the raw material mixture contains at least one Group 2 element-containing metal fluoride, the Group 2 element-containing metal fluoride may be a part of the Group 2 element source. In other words, the Group 2 element source may be partially substituted with the Group 2 element-containing metal fluoride.

When the Group 2 element source is partially substituted with a Group 2 element-containing metal fluoride, a ratio of the molar amount of the Group 2 element-containing metal fluoride with respect to the molar amount of the Group 2 element source may be, for example, 0.05 or higher but lower than 1, preferably 0.08 or higher, or 0.1 or higher, but preferably 0.8 or lower, 0.6 or lower, or 0.4 or lower.

The rare earth element in the metal fluoride may contain at least one selected from the group consisting of Sc, Y, La, Ce, Pr, Nd, Sm, Eu, Gd, Tb, Dy, Ho, Er, Tm, Yb, and Lu, preferably Eu. When the raw material mixture contains a rare earth element-containing metal fluoride, the rare earth element-containing metal fluoride may be a part of the europium source. In other words, the europium source may be partially substituted with the rare earth element-containing metal fluoride.

When the europium source is partially substituted with a rare earth element-containing metal fluoride, a ratio of the molar amount of the rare earth element-containing metal fluoride with respect to the molar amount of the europium source may be, for example, 0.05 or higher but lower than 1, preferably 0.08 or higher, or 0.1 or higher, but preferably 0.8 or lower, 0.6 or lower, or 0.4 or lower.

The Group 4 or 14 element in the metal fluoride may contain at least one selected from the group consisting of Ge, Sn, Ti, Zr, and Hf. When the raw material mixture contains a Group 4 or 14 element-containing metal fluoride, the Group 4 or 14 element-containing metal fluoride may be a part of the silicon source. In other words, the silicon source may be partially substituted with the Group 4 or 14 element-containing metal fluoride.

When the silicon source is partially substituted with a Group 4 or 14 element-containing metal fluoride, a ratio of the molar amount of the Group 4 or 14 element-containing metal fluoride with respect to the molar amount of the silicon source may be, for example, 0.05 or higher but lower than 1, preferably 0.08 or higher, or 0.1 or higher, but preferably 0.8 or lower, 0.6 or lower, or 0.4 or lower.

The Group 13 element in the metal fluoride may contain at least one selected from the group consisting of Al, Ga, and In, preferably Al. When the raw material mixture contains a Group 13 element-containing metal fluoride, the Group 13 element-containing metal fluoride may be a part of the aluminum source. In other words, the aluminum source may be partially substituted with the Group 13 element-containing metal fluoride.

When the aluminum source is partially substituted with a Group 13 element-containing metal fluoride, a ratio of the molar amount of the Group 13 element-containing metal fluoride with respect to the molar amount of the aluminum source may be, for example, 0.05 or higher but lower than 1, preferably 0.08 or higher, or 0.1 or higher, but preferably 0.8 or lower, 0.6 or lower, or 0.4 or lower.

As for the content of the metal fluoride in the raw material mixture, the molar content ratio of fluorine atom with respect to aluminum may be, for example, 0.01 to 0.3, and it is preferably 0.01 or higher but lower than 0.3, more preferably 0.015 to 0.2, still more preferably 0.02 to 0.15, yet still more preferably 0.025 to 0.1. By controlling this molar content ratio to be equal to or higher than the above-described lower limit value, the effect of the metal fluoride as a flux may be sufficiently obtained. When the raw material mixture contains a certain amount or more of a flux, the effect of the flux is saturated, and no additional effect may be expected by further increasing the amount of the flux; therefore, by controlling the molar content ratio to be equal to or lower than the above-described upper limit value, the effect of the flux may be obtained without having to incorporate the flux more than necessary.

The metal fluoride may have a purity of, for example, 95% by weight or higher, preferably 99% by weight or higher. By controlling the purity to be equal to or higher than the predetermined value, the effects of impurities are reduced, so that the light emission intensity of the resulting phosphor may be further improved. The Group 2 element-containing metal fluoride may further contain Li, Na, K, B, Al, or the like. The metal fluoride to be used may be acquired through purchasing or otherwise obtaining or the like, or a desired metal fluoride may be produced.

When the raw material mixture contains a metal fluoride, the raw material mixture may further contain a flux of other halide or the like in addition to the metal fluoride. Examples of the halide include chlorides and fluorides of rare earths, alkali metals, and the like. When the raw material mixture contains a flux, the content thereof with respect to the metal fluoride is, for example, 20% by mass or less, preferably 10% by mass or less, more preferably 1% by mass or less.

The raw material mixture, if necessary, may further contain a nitride phosphor that is separately provided. When the raw material mixture contains a nitride phosphor, the content thereof in a total amount of the raw material mixture may be, for example, 1% by mass to 50% by mass.

The raw material mixture may be provided by mixing the Group 2 element source, the europium source, the silicon source, and the aluminum source at a predetermined amount ratio. As for the mixing ratio of the components in the raw material mixture, for example, a ratio of a total molar content of the Group 2 element and europium with respect to the molar content of aluminum may be in a range of 0.8 to 1.1, preferably 0.9 to 1.05. A ratio of the molar content of europium with respect to the molar content of aluminum may be in a range of 0.002 to 0.08, preferably 0.004 to 0.075. A ratio of the molar content of silicon with respect to the molar content of aluminum may be in a range of 0.8 to 1.2, preferably 0.9 to 1.1. A ratio of a total molar content of silicon and aluminum with respect to the molar content of aluminum may be in a range of 1.8 to 2.2, preferably 1.9 to 2.1.

The mixing ratio of the components in the raw material mixture may be selected such that, for example, s, t, u, v, w, and x in the following Formula (Ia) satisfy the requirements defined below in Formula (Ia).

$$M^a_s Sr_t Eu_u Si_v Al_w N_x \qquad (Ia)$$

In Formula (Ia), $M^a$ represents a Group 2 element containing at least one selected from the group consisting of Mg, Ca, and Ba; s, t, u, v, w, and x may satisfy $0 < s < 1$, $0 \leq t < 1$, $0.002 \leq u \leq 0.08$, $0.8 \leq s + t + u \leq 1.1$, $0.8 \leq v \leq 1.2$, $0.8 \leq w \leq 1.2$, $1.8 \leq v + w \leq 2.2$, and $2.5 \leq x \leq 3.2$; and s, t, and u may satisfy $0.94 \leq s + t + u \leq 1.10$.

The raw material mixture may be obtained by weighing the respective components constituting the raw material mixture such that a desired mixing ratio is obtained, and subsequently mixing the components by, for example, a mixing method using a ball mill or the like, a mixing method using a mixing machine such as a Henschel mixer or a V-type blender, or a mixing method using a mortar and a pestle. The mixing may be dry-mixing, or wet-mixing with an addition of a solvent and the like.

A desired nitride phosphor may be obtained by performing a heat treatment of the thus obtained raw material mixture. The temperature of the heat treatment of the raw material mixture may be, for example, in a range of 1,200°C to 2,200°C, preferably 1,500°C or higher, 1,800°C or higher, 1,850°C or higher, or 1,900°C or higher, but 2,100°C or lower, 2,080°C or lower, 2,060°C or lower, or 2,000°C or lower. By performing the heat treatment of the raw material mixture at a temperature equal to or higher than the predetermined temperature, europium is made likely to penetrate into the resulting crystal structure, so that a phosphor which has a relatively large particle size because of facilitated crystal growth and exhibits a good light emission intensity is formed. Further, when the temperature of the heat treatment of the raw material mixture is equal to or lower than the predetermined temperature, decomposition of the resulting crystal structure is inhibited, so that a nitride phosphor having a crystal structure with few defects may be obtained. The heat treatment of the raw material mixture may be performed using, for example, a gas-pressurized electric furnace.

The heat treatment of the raw material mixture may be performed at a single temperature, or may be performed in multiple stages that include two or more heat treatment temperatures. When the heat treatment is performed in multiple stages, the heat treatment of a first stage may be performed at, for example, 1,200°C to 1,600°C, preferably 1,300°C to 1,500°C, and the heat treatment of a second stage may be subsequently performed while gradually raising the temperature to 1,800°C to 2,100°C, preferably 1,850°C to 2,050°C. The heat treatment performed in multiple stages may include: performing a first heat treatment of the raw material mixture at a temperature of, for example, 1,200°C to 1,600°C, preferably 1,300°C to 1,500°C to obtain a first heat-treated product; cooling this first heat-treated product obtained; and subsequently subjecting this first heat-treated product to a second heat treatment at a temperature of 1,800°C to 2,100°C, preferably 1,850°C to 2,050°C, to obtain a second heat-treated product. The heat treatment performed in multiple stages may further include performing a crushing treatment, a pulverization treatment, or the like of the first heat-treated product to obtain a pulverized product. By the heat treatment in multiple stages, a nitride phosphor capable of exhibiting a higher light emission intensity tends to be obtained.

In the heat treatment of the raw material mixture, the raw material mixture is heated from, for example, room temperature to a predetermined temperature. The heating time is, for example, 1 hour to 48 hours, preferably 2 hours to 24 hours, more preferably 3 hours to 20 hours. When the heating time is equal to or longer than the above-described lower limit value, not only the particle growth of the resulting nitride phosphor tends to proceed sufficiently, but also europium tends to be readily incorporated into the crystals of the nitride phosphor.

In the heat treatment of the raw material mixture, a retention time at a predetermined temperature may be provided. The retention time is, for example, 0.5 hours to 48 hours, preferably 1 hour to 30 hours, more preferably 2 hours to 20 hours. By setting the retention time to be equal to or longer than the above-described lower limit value, uniform particle growth may be further facilitated. Moreover, by setting the retention time to be equal to or shorter than the above-described upper limit value, decomposition of the resulting phosphor may be further inhibited.

In the heat treatment of the raw material mixture, the time of cooling from a predetermined temperature to room temperature is, for example, 0.1 hours to 20 hours, preferably 1 hour to 15 hours, more preferably 3 hours to 12 hours. It is noted here that, during the cooling from a predetermined temperature to room temperature, a retention time at a temperature selected as appropriate may be provided. This retention time is adjusted such that, for example, the light emission intensity of the resulting nitride phosphor is further improved. The retention time at a predetermined temperature during the cooling is, for example, 0.1 hours to 20 hours, preferably 1 hour to 10 hours. Further, the temperature during the retention time is, for example, 1,000°C or higher but lower than 1,800°C, preferably 1,200°C to 1,700°C.

The atmosphere for the heat treatment of the raw material mixture may be, for example, a nitrogen gas-containing atmosphere, preferably substantially a nitrogen gas atmosphere. By performing the heat treatment in a nitrogen gas-containing atmosphere, silicon contained as a raw material may be nitrided as well. In addition, decomposition of the raw materials and the phosphor that are nitrides may be inhibited. When the atmosphere of the heat treatment of the raw material mixture contains a nitrogen gas, the atmosphere may also contain hydrogen, a noble gas such as argon, and/or other gas such as carbon dioxide, carbon monoxide, oxygen, or ammonia, in addition to the nitrogen gas. In the atmosphere of the heat treatment of the raw material mixture, the content of the nitrogen gas may be, for example, 90% by volume or higher, preferably 95% by volume or higher. By controlling the content of gases containing elements other than nitrogen to be equal to or less than the predetermined value, a reduction in the light emission intensity of the resulting phosphor, which is caused by the formation of impurities by such gas components, tends to be inhibited.

The pressure in the heat treatment of the raw material mixture may be set at, for example, normal pressure to 200 MPa. From the standpoint of inhibiting decomposition of the resulting nitride phosphor, a higher pressure is more preferred, and the gauge pressure may be, for example, in a range of 0.1 MPa to 200 MPa, preferably in a range of 0.6 MPa to 1.2 MPa that imposes few restrictions on industrial equipment.

The heat treatment of the raw material mixture may be performed by loading the raw material mixture to a crucible or a boat that is formed of a material selected from the group consisting of a carbon material such as graphite, a boron nitride (BN) material, an alumina ($Al_2O_3$) material, a molybdenum (Mo) material, and a tungsten (W) material. For the heat treatment of the raw material mixture, from the standpoint of inhibiting the contamination of the resulting nitride phosphor with impurities, a crucible or a boat that is formed of a boron nitride material or a tungsten material may be preferably used.

According to an aspect of the present disclosure, the heat treatment of the raw material mixture may be performed in a closed container formed of a tungsten material. This enables the efficient production of a nitride phosphor capable of exhibiting a higher light emission intensity. The closed container in which the heat treatment of the raw material mixture is performed may be formed of substantially tungsten. The term "substantially" used herein means not to exclude impurities that are unavoidably incorporated.

The term "closed container" used herein refers to a container that may suppress contamination with solid foreign substances under ordinary conditions of handling, shipment, or storage (e.g., Japanese Pharmacopoeia, Item 37 of General Rules). The closed container is composed of, for example, a container body having an opening, and a lid for tightly closed the opening of the container body, and is capable of preventing the movement of a solid in and out of the container under the heat treatment conditions. In the closed container, the movement of a gas in and out of the container under the heat treatment conditions does not necessarily need to be completely prevented as long as it is inhibited. As for the shape of the container body of the closed container, for example, the container body may include a bottom portion and a wall portion surrounding the bottom portion, and an upper portion facing the bottom portion may form the opening. The container body may have, for example, a cylindrical shape, a polygonal column shape, or a rectangular shape. In the closed container formed of a tungsten material, at least the portion coming into contact with the raw material mixture may be formed of substantially tungsten, and the whole closed container may be formed of substantially tungsten.

The amount of the raw material mixture to be placed in the closed container may be, for example, 60% by volume to 100% by volume, preferably 75% by volume to 99% by volume, with respect to the capacity of the closed container.

The heat-treated product obtained by the heat treatment of the raw material mixture may be subjected to a combination of treatments, such as pulverization and classification, to control the particle size. By this particle size control step, phosphor particles having a desired particle size may be obtained. Specifically, the heat-treated product is coarsely pulverized (this process is hereinafter also referred to as "crushing"), and then further pulverized to a predetermined particle size using a general pulverizer, such as a ball mill, a jet mill, or a vibration mill. In a case where the resulting pulverized particles are varied in particle size, the particles may be classified to obtain a nitride phosphor having a desired particle size. The heat-treated product before or after this classification may be brought into contact with deionized water, an acidic solution, or a basic solution to perform a washing treatment for the purpose of removing thermally decomposed products adhering to the surface of the heat-treated product.

A method of producing a nitride phosphor according to an embodiment of the present disclosure may include: performing a first heat treatment of a raw material mixture that contains a Group 2 element source, a europium source, a silicon source, and an aluminum source, at a temperature of 1,200°C to 1,600°C in a closed container formed of tungsten to obtain a first heat-treated product; and subjecting this first heat-treated product to a second heat treatment at a temperature of 1,800°C to 2,100°C in a closed container formed of tungsten to obtain a second heat-treated product, and the Group 2 element source may contain a hydride containing at least one Group 2 element, and at least one selected from the group consisting of Group 2 element-containing amide compounds and Group 2 element-containing imide compounds.

Light Emitting Device

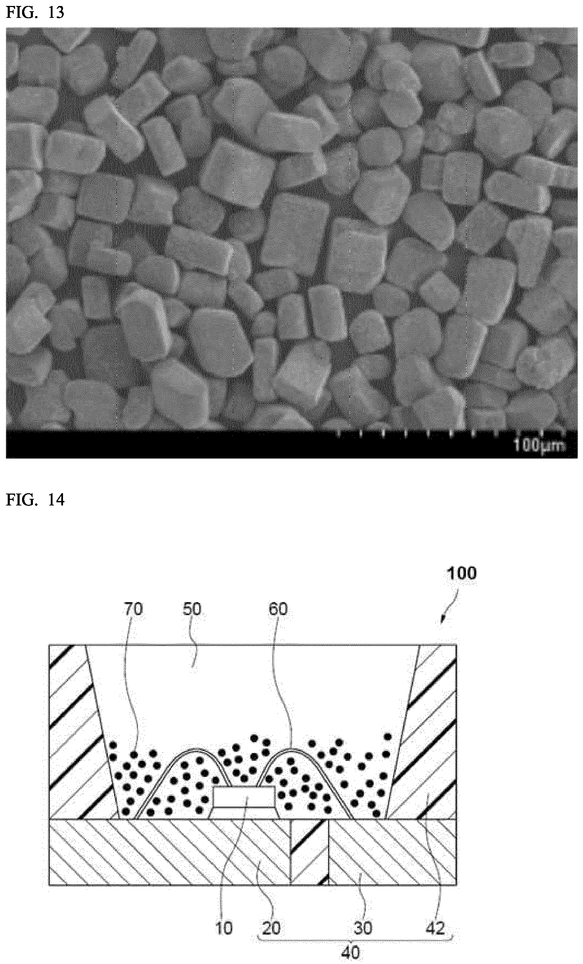

A light emitting device according to an embodiment of the present disclosure may include: a fluorescent member containing the above-described nitride phosphor; and a light emitting element having an emission peak wavelength in a range of 365 nm to 500 nm. A light emitting device 100 will now be described referring to FIG. 14. The light emitting device 100 is an example of a surface-mount light emitting device. The light emitting device 100 includes: a light emitting element 10 of a gallium nitride compound semiconductor having an emission peak wavelength in a range of 380 nm to 470 nm; and a formed body 40 in which the light emitting element 10 is disposed. The formed body 40 is obtained by molding a first lead 20, a second lead 30, and a resin part 42 together. The formed body 40 forms a recess defined by a bottom surface and a lateral surface of the formed body 40, and the light emitting element 10 is disposed on the bottom surface of this recess. The light emitting element 10 has a pair of positive and negative electrodes, which are electrically connected to the first lead 20 and the second lead 30, respectively, via a wire 60. The light emitting element 10 is covered with a fluorescent member 50. The fluorescent member 50 contains, for example, a phosphor 70 that converts the wavelength of light emitted from the light emitting element 10, and a resin.

The light emitting element 10 may have an emission peak wavelength in a wavelength range of preferably 380 nm to 470 nm, or 400 nm to 460 nm. The use of the light emitting element 10 having an emission peak wavelength in this range as a light source enables the construction of the light emitting device 100 that emits a mixed color light of the light emitted from the light emitting element 10 and the fluorescence emitted from the fluorescent member 50. In addition, a portion of the light emitted from the light emitting element 10 may be effectively utilized as a portion of the light emitted from the light emitting device 100 to the outside; therefore, the light emitting device 100 may be provided with a high light emission efficiency.

The light emitting element 10 may have an emission spectrum with a half-value width of, for example, 30 nm or less. As the light emitting element, it is preferred to use, for example, a semiconductor light emitting element in which a nitride-based semiconductor is used. By using such a semiconductor light emitting element as an excitation light source, a highly efficient light emitting device that has a high linearity of output with respect to input and is strong and stable against mechanical impact may be obtained.

The fluorescent member 50 contains at least the nitride phosphor and, if necessary, may also contain other phosphor, a resin, and the like. In addition to the nitride phosphor, the fluorescent member may contain a phosphor other than the nitride phosphor. By incorporating other phosphor into the fluorescent member, a light emitting device that emits a mixed color of the light emitted from the light emitting element and the light emitted from the nitride phosphor and the other phosphor may be constructed.

Examples of the other phosphor include phosphors having a composition represented by any one of the following Formulae (IIa) to (IIi), and the other phosphor preferably contains at least one phosphor having a composition represented by a formula selected from the group consisting of Formulae (IIa) to (IIi), more preferably contains at least one phosphor having a composition represented by Formula (IIa), (IIb), (IIc), (IId), (IIe), (IIg), (IIh), or (IIi). This is because, by incorporating any of these other phosphors, a light emitting device that has good color rendering properties and a high light emission efficiency may be obtained. The light emitting device may contain the other phosphor singly, or in combination of two or more kinds thereof.

$$(Y,Gd,Tb,Lu)_3(Al,Ga)_5O_{12}{:}Ce \qquad (IIa)$$

$$(Ca,Sr,Ba)_2SiO_4{:}Eu \qquad (IIb)$$

$$Si_{6-p}Al_pOpN_{8-p}{:}Eu(0 < p \le 4.2) \qquad (IIc)$$

$$(Ca,Sr)_8MgSi_4O_{16}(F,Cl,Br)_2{:}Eu \qquad (IId)$$

$$(La,Y,Gd,Lu)_3Si_6N_{11}{:}Ce \qquad (IIe)$$

$$(Ca,Sr,Ba)_2Si_5N_8{:}Eu \qquad (IIg)$$

$$(Ca,Sr,Ba)LiAl_3N_4{:}Eu \qquad (IIh)$$

$$(Ca,Sr,Ba)_{10}(PO_4)_6(F,Cl,Br)_2{:}Eu \qquad (IIi)$$

Examples of the other phosphor also include phosphors having a composition represented by either of the following Formulae (IIj) and (IIk), and it is also preferred that the other phosphor contain at least one phosphor having a composition represented by a formula selected from the group consisting of Formulae (IIj) and (IIk). It is more preferred to incorporate any of these other phosphors from the standpoint of obtaining a light emitting device that has good color rendering properties and a high light emission efficiency.

$$A^1_c[M^1_{1-b}Mn_bF_d] \qquad \text{(IIj)}$$

$$A^2_f[M^2_{1-e}Mn_eF_g] \qquad \text{(IIk)}$$

In Formula (IIj), $A^1$ contains at least one selected from the group consisting of Li, Na, K, Rb, and Cs; $M^1$ contains at least one of Si or Ge, and optionally further contains at least one element selected from the group consisting of Group 4 elements and Group 14 elements; b satisfies $0 < b < 0.2$; c represents an absolute value of the charge of $[M^1_{1-b}Mn_bF_d]$ ion; and d satisfies $5 < d < 7$.

In Formula (IIk), $A^2$ contains at least one selected from the group consisting of Li, Na, K, Rb, and Cs; $M^2$ contains at least Si and Al, and optionally further contains at least one element selected from the group consisting of Group 4 elements, Group 13 elements, and Group 14 elements; e satisfies $0 < e < 0.2$; f represents an absolute value of the charge of $[M^2_{1-e}Mn_eF_g]$ ion; and g satisfies $5 < g < 7$.

The other phosphor may have an average particle size of, for example, 2 μm to 35 pm, preferably 5 μm to 30 μm. When the average particle size of the other phosphor is equal to or larger than the above-described lower limit value, the absorption rate of light emitted from an excitation light source is improved, so that a light emitting device having a higher light emission intensity with a desired chromaticity may be obtained. Further, when the average particle size of the other phosphor is equal to or smaller than the above-described upper limit value, the workability of incorporating the other phosphor into a fluorescent member of a light emitting device may be improved in the light emitting device production process.

The fluorescent member 50 may contain at least one resin in addition to the nitride phosphor. Examples of the resin include epoxy resins and silicone resins.

The fluorescent member 50, if necessary, may further contain other components in addition to the nitride phosphor. Examples of the other components include: fillers, such as silica, barium titanate, titanium oxide, and aluminum oxide; light stabilizers; and colorants. When the fluorescent member 50 contains other component such as a filler, the content thereof may be 0.01 to 20 parts by mass with respect to 100 parts by mass of the resin.

EXAMPLES

The present invention will now be described more concretely by way of Examples; however, the present invention is not limited thereto by any means.

Reference Example 1: Provision of Strontium Hydride ($SrH_2$)

Sr metal was placed on an alumina boat in a glove box having an inert (Ar) atmosphere, and this was heat-treated at 600°C for 12 hours under a hydrogen-containing argon atmosphere (Ar flow rate: 5 L/min, $H_2$ flow rate: 2.5 L/min) in a tube furnace to obtain a heat-treated product. Subsequently, the thus obtained heat-treated product was coarsely pulverized and mixed. The thus heat-treated product coarsely pulverized was again heat-treated under the hydrogen-containing argon atmosphere in a manner the same as or similar to that described above. The heat treatment and the coarse pulverization were repeated four times. Thereafter, the resultant was pulverized using a mortar and a pestle and classified in a glove box having an inert (Ar) atmosphere, whereby a powder of Reference Example 1 was obtained. The X-ray diffraction (XRD) spectrum of the thus obtained powder was measured in an inert atmosphere using a sample horizontal-type multi-purpose X-ray diffractometer (product name: ULTIMA IV, manufactured by Rigaku Corporation; X-ray source: CuKα radiation ($\lambda = 1.5418$ Å), tube voltage = 40 kV, tube current = 40 mA). From the thus obtained powder X-ray diffraction spectrum, the powder of Reference Example 1 was confirmed to be strontium hydride ($SrH_2$).

Reference Example 2: Provision of Strontium Source

Sr metal was placed on an alumina boat in a glove box having an inert (Ar) atmosphere, and this was heat-treated at 300°C for 12 hours under a hydrogen-containing nitrogen atmosphere ($N_2$ flow rate: 21.5 L/min, $H_2$ flow rate: 0.9 L/min) in a tube furnace to obtain a heat-treated product. Subsequently, the thus obtained heat-treated product was coarsely pulverized and mixed. The thus heat-treated product coarsely pulverized was again heat-treated under the hydrogen-containing nitrogen atmosphere in a manner the same as or similar to that described above. The heat treatment and the coarse pulverization were repeated three times. Thereafter, the resultant was pulverized using a mortar and a pestle and classified in a glove box having an inert (Ar) atmosphere, whereby a powder of Reference Example 2 was obtained. The X-ray diffraction (XRD) spectrum of the thus obtained powder was measured in an inert atmosphere using a sample horizontal-type multi-purpose X-ray diffractometer (product name: ULTIMA IV, manufactured by Rigaku Corporation; X-ray source: CuK$\alpha$ radiation ($\lambda$ = 1.5418 Å), tube voltage = 40 kV, tube current = 40 mA). From the thus obtained powder X-ray diffraction spectrum, the powder of Reference Example 2 was confirmed to be a mixture of strontium imide and strontium hydride (x(SrNH) + (1 - x)(SrH$_2$), x = 1/4 equivalent; hereinafter, may be abbreviated as "Sr$_3$N$_2$").

Example 1

The thus provided powder of Reference Example 2 (x(SrNH) + (1 - x)(SrH$_2$), x = 1/4 equivalent; Sr$_3$N$_2$), calcium nitride (Ca$_3$N$_2$), calcium fluoride (CaF$_2$), europium nitride (EuN), aluminum nitride (AlN), and silicon nitride (Si$_3$N$_4$) were used as raw materials. These compounds were each weighed in a glove box having an inert atmosphere such that an element molar ratio of Ca(Ca$_3$N$_2$):Ca(CaF$_2$):Sr:Eu:Al:Si:F = 0.021:0.009:0.965:0.005:1:1:0.009 was achieved as a mixing composition ratio, and the thus weighed compounds were mixed to obtain a raw material mixture. The thus obtained raw material mixture was loaded to a crucible formed of tungsten, which was subsequently tightly closed with a lid. A first-stage heat treatment was performed in a nitrogen gas atmosphere under the conditions of a gauge pressure of 0.92 MPa, a heat treatment temperature of 1,400°C, and a retention time of 3 hours to obtain a precursor. This precursor was pulverized and thereby homogenized in a glove box having an inert atmosphere, and again loaded to a crucible formed of tungsten, which was subsequently tightly closed with a lid. A second-stage heat treatment was performed in a nitrogen gas atmosphere under the conditions of a gauge pressure of 0.92 MPa, a heat treatment temperature of 1,950°C, and a retention time of 15 hours. Thereafter, treatments such as pulverization, dispersion, and classification were performed to obtain a nitride phosphor powder of Example 1.

Comparative Example 1

A nitride phosphor powder of Comparative Example 1 was obtained in the same manner as in Example 1, except that Ca$_3$N$_2$, CaF$_2$, SrN$_x$ (x = 2/3 equivalent; mixture of Sr$_2$N and SrN), AlN$_3$, Si$_3$N$_4$, and EuN were used as raw materials, and that a raw material mixture was obtained by mixing these raw materials such that a molar ratio of Ca(Ca$_3$N$_2$):Ca(CaF$_2$):Sr:Eu:Al:Si:F = 0.009:0.021:0.965:0.005:1:1:0.042 was achieved as a mixing amount ratio.

Examples 2 to 8

Nitride phosphor powders of Examples 2 to 8 were obtained in a manner the same as or similar to that in Example 1, except that raw material mixtures were obtained such that the molar ratios of the elements therein were the respective mixing composition ratios shown in Table 1.

Comparative Examples 2 to 4

Nitride phosphor powders of Comparative Examples 2 to 4 were obtained in a manner the same as or similar to that in Comparative Example 1, except that raw material mixtures were obtained such that the molar ratios of the elements therein were the respective mixing composition ratios shown in Table 1.

Example 9

A nitride phosphor powder of Example 9 was obtained in a manner the same as or similar to that in Example 1, except that the powder (SrH$_2$) of Reference Example 1 was used as a strontium source in place of the powder of Reference Example 2, and that a raw material mixture was obtained such that the molar ratios of the elements therein were the respective mixing composition ratios shown in Table 1.

[Table 1]

| | Sr source | Mixing composition ratio | | | | Ca Soruce ratio | | Composition analysis | | | |
|---|---|---|---|---|---|---|---|---|---|---|---|
| | | Sr | Ca | Eu | F | Ca$_3$N$_2$ | CaF$_2$ | Sr | Ca | Eu | Si |
| Comparative Example 1 | SrNx | 0.965 | 0.03 | 0.005 | 0.042 | 0.009 | 0.0021 | 0.922 | 0.032 | 0.005 | 1.03 |
| Example 1 | Sr3N2 | 0.965 | 0.03 | 0.005 | 0.009 | 0.025 | 0.004 | 0.926 | 0.027 | 0.005 | 1.01 |

(continued)

| | Sr source | Mixing composition ratio | | | | Ca Soruce ratio | | Composition analysis | | | |
|---|---|---|---|---|---|---|---|---|---|---|---|
| | | Sr | Ca | Eu | F | $Ca_3N_2$ | $CaF_2$ | Sr | Ca | Eu | Si |
| Comparative Example 2 | SrNx | 0.939 | 0.049 | 0.012 | 0.049 | 0.025 | 0.025 | 0.890 | 0.051 | 0.012 | 1.10 |
| Example 2 | Sr3N2 | 0.939 | 0.049 | 0.012 | 0.049 | 0.025 | 0.025 | 0.865 | 0.049 | 0.012 | 1.00 |
| Example 3 | | 0.939 | 0.049 | 0.012 | 0.03 | 0.035 | 0.015 | 0.893 | 0.050 | 0.012 | 1.03 |
| Example 4 | | 0.939 | 0.049 | 0.012 | 0.01 | 0.044 | 0.005 | 0.897 | 0.050 | 0.012 | 1.02 |
| Comparative Example 3 | SrNx | 0.923 | 0.049 | 0.028 | 0.03 | 0.034 | 0.015 | 0.878 | 0.050 | 0.029 | 1.00 |
| Example 5 | Sr3N2 | 0.923 | 0.049 | 0.028 | 0.03 | 0.034 | 0.015 | 0.851 | 0.049 | 0.028 | 1.00 |
| Example 6 | | 0.923 | 0.049 | 0.028 | 0.02 | 0.039 | 0.01 | 0.871 | 0.045 | 0.028 | 0.99 |
| Example 7 | | 0.923 | 0.049 | 0.028 | 0.01 | 0.044 | 0.005 | 0.878 | 0.045 | 0.029 | 1.00 |
| Example 8 | | 0.907 | 0.068 | 0.025 | 0.02 | 0.058 | 0.01 | 0.870 | 0.068 | 0.025 | 1.01 |
| Comparative Example 4 | SrNx | 0.867 | 0.13 | 0.003 | 0.092 | 0.084 | 0.045 | 0.833 | 0.136 | 0.004 | 1.07 |
| Example 9 | SrH2 | 0.867 | 0.13 | 0.003 | 0.031 | 0.114 | 0.016 | 0.830 | 0.129 | 0.004 | 1.00 |

Composition Analysis

For each of the nitride phosphors of Examples and Comparative Examples, the constituent elements were analyzed using a scanning X-ray fluorescence (XRF) spectrometer (product name: ZSX Primus II, manufactured by Rigaku Corporation), an ion chromatography (IC) apparatus (product name: Dionex Integrion HPIC, manufactured by Thermo Fisher Scientific Inc.), and an oxygen-nitrogen-hydrogen analyzer (product name: EMGA-930, manufactured by HORIBA, Ltd.), and the molar ratio of each element was calculated. The molar ratio of each element was calculated taking the molar ratio of Al in each composition as 1. The results thereof are shown in Table 1.

Average Circularity

The average circularity of each nitride phosphor obtained in Examples and Comparative Examples was determined as follows. From an image captured by observation with an optical microscope, ten particles were arbitrarily selected, excluding those phosphor particles recognized in the image which overlap each other, whose overall shapes were not visible, or which were obviously fine. For each of the thus selected particles, the projected area ($S$ ($m^2$)) and the circumferential length ($L$ (m) were measured using an image processing software (MORPHOLOGI G3S, manufactured by Malvern Panalytical Ltd.), and the circularity of each particle was calculated using the following equation. An arithmetic mean value was determined for the thus calculated circularity values of the respective particles, and this value was rounded off to two decimal places and defined as the average circularity of each nitride phosphor obtained in Examples and Comparative Examples. The results thereof are shown in Table 2.

$$\text{Circularity} = 4\pi S/L^2$$

Average Aspect Ratio

The average aspect ratio of each nitride phosphor obtained in Examples and Comparative Examples was determined as follows. From an image captured by observation with an optical microscope, ten particles were arbitrarily selected, excluding those phosphor particles recognized in the image which overlap each other, whose overall shapes were not visible, or which were obviously fine. For each of the thus selected particles, the major axis and the minor axis were measured using an image processing software (MORPHOLOGI G3S, manufactured by Malvern Panalytical Ltd.), and the ratio of the minor axis with respect to the major axis (minor axis/major axis) was calculated as the aspect ratio. An arithmetic mean value was determined for the thus calculated aspect ratios of the respective particles, and this value was rounded off to two decimal places and defined as the average aspect ratio of each nitride phosphor obtained in Examples and Comparative Examples. The results thereof are shown in Table 2.

Powder Measurement

For each of the nitride phosphors obtained in Examples and Comparative Examples, the average particle size was determined by measuring the specific surface area utilizing the flow resistance of air in accordance with an air permeability method (FSSS method). An average particle size of particles determined by an air permeability method is also called Fisher Sub-Sieve Sizer's Number. Specifically, using Fisher Sub-Sieve Sizer Model 95 (manufactured by Fisher Scientific, Inc.) under an environment of 25°C and 70% RH, each of the nitride phosphors obtained in Examples and Comparative Examples was weighed in an amount of 1 cm$^3$ as a sample and packed into a special tubular vessel, and a dry air was subsequently passed therethrough at a constant pressure. The specific surface area was read from the difference in pressure, and the average particle size was calculated by an FSSS method. The results thereof are shown in Table 2.
For each of the nitride phosphors obtained in Examples and Comparative Examples, the volume-average particle size distribution was measured using a particle size distribution analyzer (product name: MASTER SIZER 3000, manufactured by Malvern Panalytical, Ltd.) based on a laser diffraction method, and the volume-average particle size (median diameter: Dm) corresponding to a cumulative frequency of 50% from the small diameter side in the thus measured particle size distribution, as well as the logarithmic standard deviation ($\sigma$log) were calculated. The results thereof are shown in Table 2. In Table 2, the ratio (D/Dm) of the average particle size (D) determined by the air permeability method with respect to the volume-average particle size is also shown.
For each of the nitride phosphors obtained in Examples and Comparative Examples, using a quantum efficiency measurement system (product name: QE-2000, manufactured by Otsuka Electronics Co., Ltd.), the emission spectrum was measured by irradiating each nitride phosphor with a light having an emission peak wavelength of 450 nm. From the thus obtained emission spectrum, the chromaticity coordinates (x, y), the brightness (Y), the light emission intensity (ENG), and the emission peak half-value width were determined. The results thereof are shown in Table 2.

Table 2

| | Average circularity | Average aspect ratio | Particle size | | | | Powder emission characteristics | | | | |
| | | | D (μm) | Dm (μm) | $\sigma$log | D/Dm | x | y | Y | ENG | Half-value width (nm) |
|---|---|---|---|---|---|---|---|---|---|---|---|
| Comparative Example 1 | 0.81 | 0.53 | 20.5 | 27.6 | 0.389 | 0.74 | 0.621 | 0.378 | 76.3 | 113.6 | 72.2 |
| Example 1 | 0.90 | 0.75 | 22.5 | 29.6 | 0.361 | 0.76 | 0.621 | 0.378 | 78.4 | 116.5 | 71.9 |
| Comparative Example 2 | 0.79 | 0.51 | 17.0 | 26.1 | 0.395 | 0.65 | 0.643 | 0.356 | 63.5 | 115.3 | 74.0 |
| Example 2 | 0.90 | 0.74 | 22.5 | 30.0 | 0.315 | 0.75 | 0.644 | 0.355 | 62.8 | 113.7 | 71.8 |
| Exampl e3 | 0.90 | 0.74 | 22.5 | 28.5 | 0.306 | 0.79 | 0.644 | 0.356 | 62.8 | 113.4 | 71.8 |
| Example 4 | 0.90 | 0.74 | 24.0 | 28.4 | 0.305 | 0.85 | 0.643 | 0.356 | 61.9 | 110.9 | 71.6 |
| Comparative Example 3 | 0.71 | 0.44 | 18.0 | 26.4 | 0.375 | 0.68 | 0.660 | 0.340 | 51.0 | 114.7 | 74.0 |
| Example 5 | 0.89 | 0.72 | 23.0 | 29.4 | 0.359 | 0.78 | 0.663 | 0.337 | 45.9 | 106.3 | 72.9 |
| Example 6 | 0.89 | 0.75 | 23.5 | 28.9 | 0.362 | 0.81 | 0.661 | 0.338 | 46.4 | 104.8 | 72.7 |
| Example 7 | 0.90 | 0.73 | 24.0 | 26.7 | 0.317 | 0.90 | 0.660 | 0.339 | 46.2 | 103.6 | 72.6 |
| Example 8 | 0.88 | 0.74 | 20.5 | 25.5 | 0.373 | 0.80 | 0.661 | 0.338 | 46.5 | 106.1 | 73.3 |
| Comparative Example 4 | 0.73 | 0.44 | 18.0 | 28.8 | 0.423 | 0.63 | 0.624 | 0.375 | 70.3 | 111.5 | 75.9 |
| Example 9 | 0.90 | 0.75 | 22.0 | 25.5 | 0.317 | 0.86 | 0.621 | 0.378 | 71.3 | 109.9 | 75.5 |

SEM Images

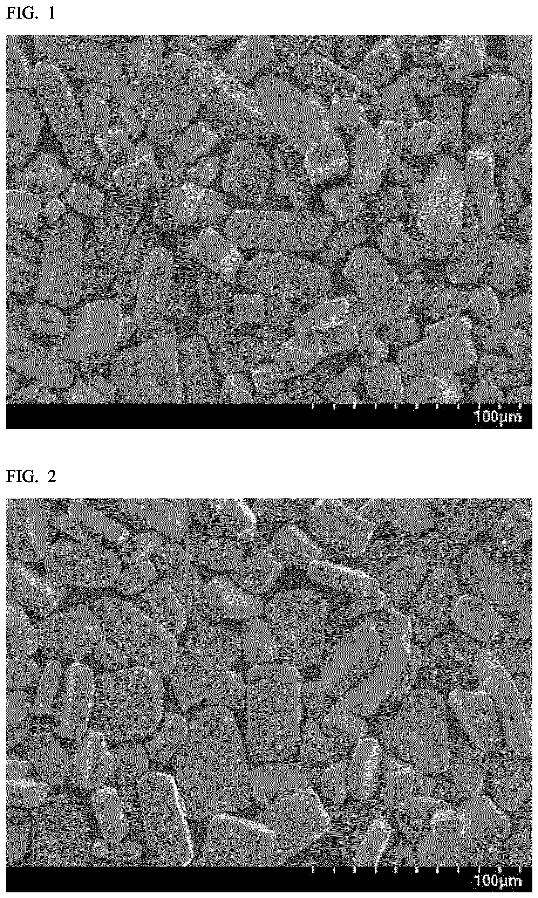

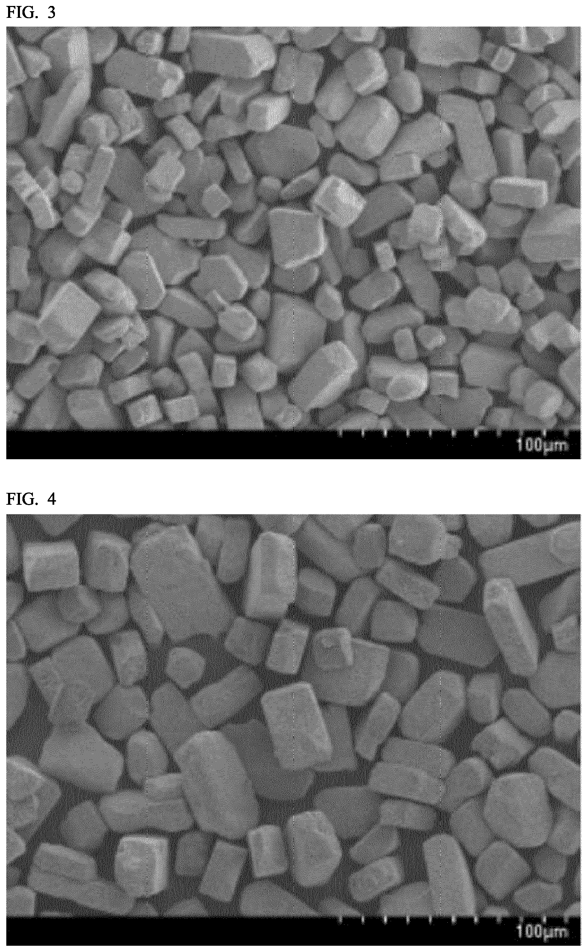

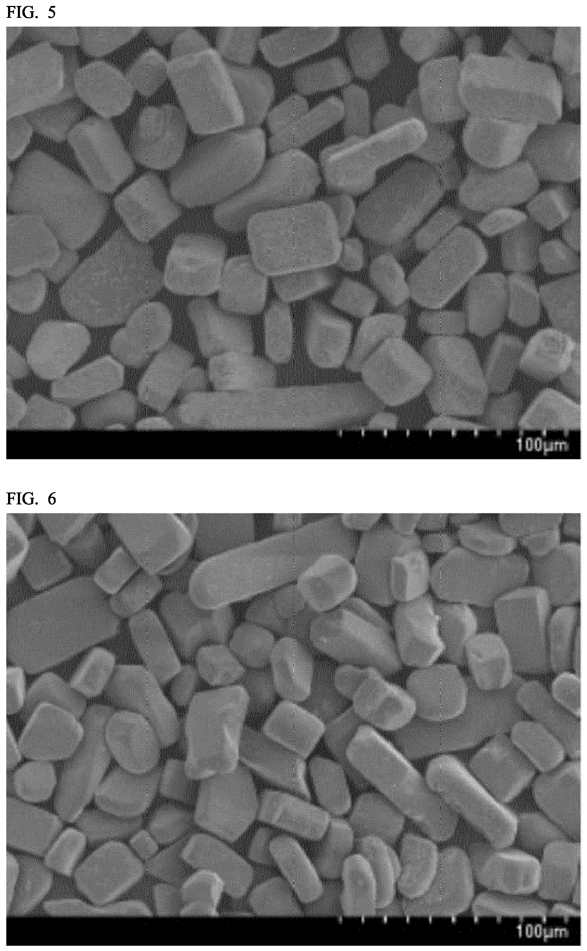

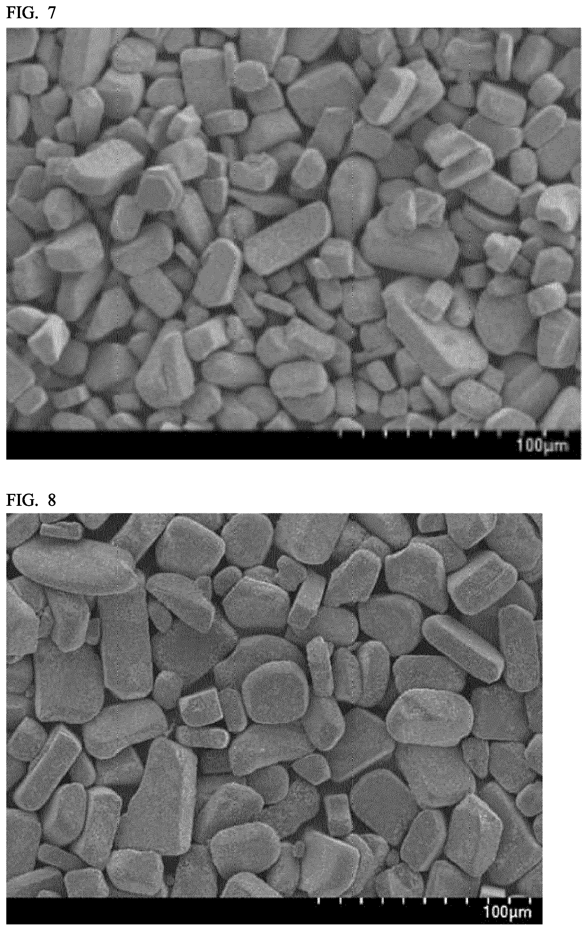

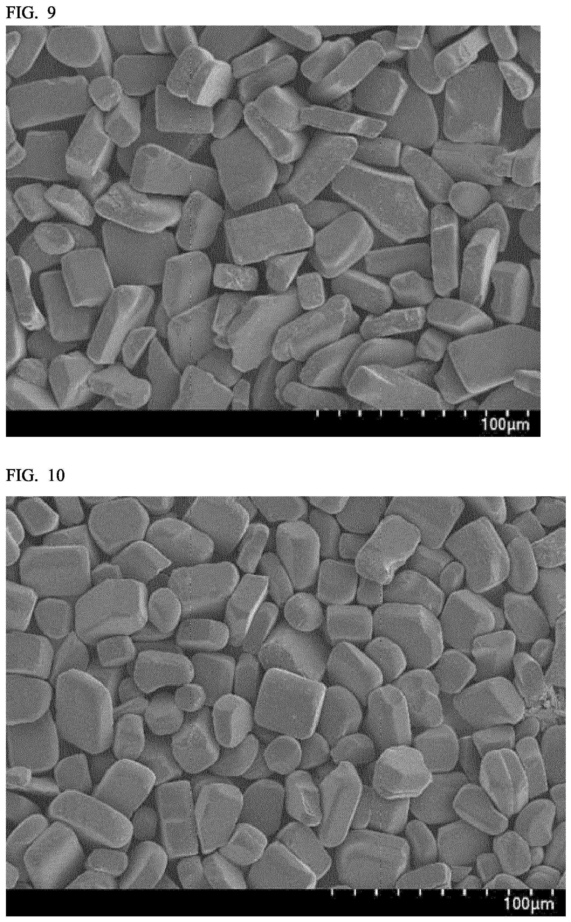

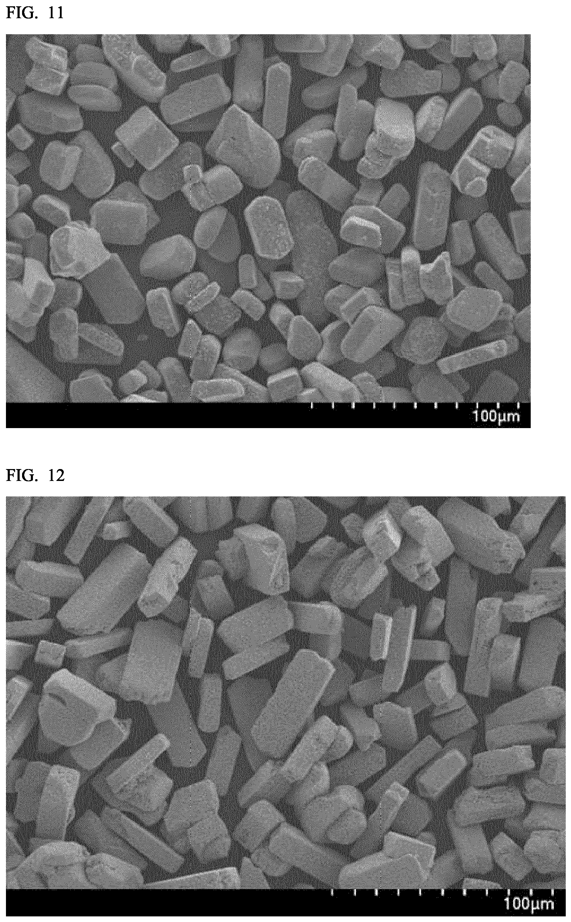

SEM images of the nitride phosphors obtained in Examples 1 to 9 and Comparative Examples 1 to 4 were obtained using a scanning electron microscope (SEM; product name: SU3500, manufactured by Hitachi High-Technologies Corporation). FIG. 1 and FIG. 2 are SEM images of the nitride phosphors of Comparative Example 1 and Example 1, respectively. FIG. 3 and FIGs. 4 to 6 are SEM images of the nitride phosphors of Comparative Example 2 and Examples 2 to 4, respectively. FIG. 7 and FIGs. 8 to 11 are SEM images of the nitride phosphors of Comparative Example 3 and Examples 5 to 8, respectively. FIG. 12 and FIG. 13 are SEM images of the nitride phosphors of Comparative Example 4 and Example 9, respectively.

It can be confirmed that, as compared to the nitride phosphors of Comparative Examples, the nitride phosphors obtained in Examples were more uniform and larger particles having an average circularity and an average aspect ratio in the respective predetermined ranges with improved $\sigma$log and D/Dm.

Production of Light Emitting Devices

Using each of the nitride phosphors obtained in Examples and Comparative Examples, a first light emitting device, a second light emitting device, and a third light emitting device were produced in the below-described manner.

First Light Emitting Device

As a light emitting element, an LED chip composed of a nitride semiconductor having an emission peak wavelength of 455 nm was provided. As illustrated in FIG. 14, a light emitting element 10 was disposed on the bottom surface of a recessed shape of a formed body 40, and connected to each of a first lead 20 and a second lead 30 via a wire 60. A first phosphor (SCASN) which was the nitride phosphor obtained in Example 1 or Comparative Example 1, a second phosphor (GYAG) which was a phosphor having a composition of $Y_3(Al,Ga)_5O_{12}$:Ce, a third phosphor (YAG) which was a phosphor having a composition of $Y_3Al_5O_{12}$:Ce, and a fourth phosphor (KSF) which was a phosphor having a composition of $K_2[Si_{1-b}Mn_bF_6]$ (0 < b < 0.2) were combined at the mixing ratio shown in Table 3 such that the emission color chromaticity coordinates (x,y) were x = 0.346 and y = about 0.355 (about 5,000 K in color temperature), and the resultant was added to and mixed with a silicone resin to disperse the phosphors in the silicone resin, thereby obtaining a composition for a wavelength conversion member. This composition for a wavelength conversion member was injected into the recessed portion of the formed body 40, and the silicone resin was cured to form a fluorescent member 50, whereby a first light emitting device was obtained.

Second Light Emitting Device

A second light emitting device was obtained in a manner the same as or similar to that the first light emitting device, except that a first phosphor (SCASN) which was the nitride phosphor obtained in Example 1 or Comparative Example 1 and a second phosphor which was a phosphor having a composition of $Y_3Al_5O_{12}$:Ce were combined at the mixing ratio shown in Table 4 such that the mixed color light emitted by the resulting light emitting device had chromaticity coordinates (x,y) of x = 0.563 and y = about 0.416 (umber color), and the resultant was added to and mixed with a silicone resin to disperse the phosphors in the silicone resin, thereby obtaining a composition for a fluorescent member.

Third Light Emitting Device

A third light emitting device was obtained in a manner the same as or similar to that the first light emitting device, except that each nitride phosphor obtained in Examples 1 to 10 and Comparative Examples 1 to 4 was added in the amount shown in Table 5 with respect to 100 parts by mass of a silicone resin, and the resultant was dispersed with mixing and then further defroamed to obtain a composition for a fluorescent member.

Evaluation of Light Emitting Devices

For each of the above-obtained light emitting devices, the relative luminous flux (%) was measured in the following manner.

The luminous flux of the first light emitting device and that of the second light emitting device were measured using an integral total luminous flux analyzer. The relative luminous flux of the first light emitting device and that of the second light emitting device are shown in Tables 3 and 4, respectively.

With regard to the chromaticity of the third light emitting device, the chromaticity coordinates (x, y) in the chromaticity coordinate system of the CIE1931 chromaticity diagram were determined using an optical measurement

**EP 4 707 358 A1**

system combining a multi-channel spectrometer and an integral sphere. In each of Examples and Comparative Examples, specifically, the chromaticity coordinates (x, y) of five light emitting devices were determined, and an arithmetic mean value thereof was defined as the chromaticity coordinates of each light emitting device of Examples and Comparative Examples. It is noted here that the dominant wavelength of each light emitting device was defined as the wavelength at an intersection between an extended straight line connecting the chromaticity point W of white color ($x_w$ = 0.33333, $y_w$ = 0.33333) with the chromaticity coordinates (x,y) of each light emitting device, and the spectral locus on the chromaticity diagram of JIS Z8701.

The luminous flux of the third light emitting device was measured using an integral total luminous flux analyzer. Table 5 shows: the relative luminous flux of the light emitting device using the nitride phosphor of Example 1 based on the luminous flux (100%) of the light emitting device using the nitride phosphor of Comparative Example 1; the relative luminous flux of each of the light emitting devices using the nitride phosphors of Examples 2 to 4 based on the luminous flux (100%) of the light emitting device using the nitride phosphor of Comparative Example 2; the relative luminous flux of each of the light emitting devices using the nitride phosphors of Examples 5 to 8 based on the luminous flux (100%) of the light emitting device using the nitride phosphor of Comparative Example 3; and the relative luminous flux of the light emitting device using the nitride phosphor of Example 9 based on the luminous flux (100%) of the light emitting device using the nitride phosphor of Comparative Example 4.

Table 3

| | Mixing ratio (%) | | | | Relative luminous flux (%) |
|---|---|---|---|---|---|
| | First phosphor (SCASN) | Second phosphor (GYAG) | Third phosphor (YAG) | Forth phosphor (KSF) | |
| Com parative Example 1 | 2.0 | 14.9 | 59.6 | 23.4 | 100 |
| Example 1 | 2.1 | 14.6 | 58.6 | 24.7 | 100.3 |

Table 4

| | Mixing ratio (%) | | Relative luminous flux (%) |
|---|---|---|---|
| | First phosphor (SCASN) | Second phosphor (YAG) | |
| Comparative Example 1 | 46.5 | 53.5 | 100 |
| Example 1 | 46.5 | 53.5 | 101.4 |

Table 5

| | Mixing amount (Part by mass) | Dominant wavelength (nm) | Relative luminous flux (%) |
|---|---|---|---|
| Comparative Example 1 | 140 | 601 | 100 |
| Example 1 | 160 | 601 | 101.1 |
| Comparative Example 2 | 120 | 607 | 100 |
| Example 2 | 150 | 607 | 101.3 |
| Example 3 | 150 | 607 | 100.4 |
| Example 4 | 150 | 607 | 104.3 |
| Comparative Example 3 | 150 | 614 | 100 |
| Example 5 | 150 | 614 | 101.4 |
| Example 6 | 150 | 614 | 107.3 |
| Example 7 | 150 | 614 | 105.6 |
| Example 8 | 150 | 614 | 102.6 |
| Comparative Example 4 | 160 | 602 | 100 |
| Example 9 | 160 | 602 | 107.6 |

As shown in Tables 3 to 5, the light emitting devices using the nitride phosphors of Examples exhibited a high luminous flux.

It is to be understood that although the present invention has been described with regard to preferred embodiments thereof, various other embodiments and variants may occur to those skilled in the art, which are within the scope and spirit of the invention, and such other embodiments and variants are intended to be covered by the following claims.

Although the present disclosure has been described with reference to several exemplary embodiments, it is to be understood that the words that have been used are words of description and illustration, rather than words of limitation. Changes may be made within the purview of the appended claims, as presently stated and as amended, without departing from the scope and spirit of the disclosure in its aspects. Although the disclosure has been described with reference to particular examples, means, and embodiments, the disclosure may be not intended to be limited to the particulars disclosed; rather the disclosure extends to all functionally equivalent structures, methods, and uses such as are within the scope of the appended claims.

One or more examples or embodiments of the disclosure may be referred to herein, individually and/or collectively, by the term "disclosure" merely for convenience and without intending to voluntarily limit the scope of this application to any particular disclosure or inventive concept. Moreover, although specific examples and embodiments have been illustrated and described herein, it should be appreciated that any subsequent arrangement designed to achieve the same or similar purpose may be substituted for the specific examples or embodiments shown. This disclosure may be intended to cover any and all subsequent adaptations or variations of various examples and embodiments. Combinations of the above examples and embodiments, and other examples and embodiments not specifically described herein, will be apparent to those of skill in the art upon reviewing the description.

In addition, in the foregoing Detailed Description, various features may be grouped together or described in a single embodiment for the purpose of streamlining the disclosure. This disclosure may be not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The above disclosed subject matter shall be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure may be determined by the broadest permissible interpretation of the following claims and their equivalents, and shall not be restricted or limited by the foregoing detailed description.

All publications, patent applications, and technical standards mentioned in this specification are herein incorporated by reference to the same extent as if each individual publication, patent application, or technical standard was specifically and individually indicated to be incorporated by reference.


**Claims**

1.   A nitride phosphor, having a composition that comprises Eu, Si, Al, N, and a Group 2 element containing at least one selected from the group consisting of Mg, Ca, Sr, and Ba,
wherein

with respect to a molar content of Al in the composition, a ratio of a total molar content of the Group 2 element and Eu is in a range of 0.8 to 1.1, a ratio of a molar content of Eu is in a range of 0.002 to 0.08, a ratio of a molar content of Si is in a range of 0.8 to 1.2, and a ratio of a total molar content of Si and Al is in a range of 1.8 to 2.2, and the nitride phosphor has an average value of an aspect ratio, which is a minor-axis-to-major-axis ratio, in a range of 0.72 to 0.77, and an average circularity in a range of 0.82 to 0.92.

2.   The nitride phosphor according to claim 1, having a volume-average particle size in a range of 20 $\mu$m to 40 $\mu$m.

3.   The nitride phosphor according to claim 1 or 2, wherein a ratio of an average particle size determined by an air permeability method to a volume-average particle size is in a range of 0.75 to 0.92.

4.   The nitride phosphor according to any one of claims 1 to 3, wherein a logarithmic standard deviation of a volume-based particle size distribution is 0.25 or more but less than 0.38.

5.   The nitride phosphor according to any one of claims 1 to 4, having a composition represented by the following Formula

(I):

$$M^a_sSr_tEu_uSi_vAl_wN_x \qquad (I),$$

wherein, $M^a$ represents a Group 2 element containing at least one selected from the group consisting of Mg, Ca, and Ba; and s, t, u, v, w, and x satisfy $0 \leq s < 1$, $0 \leq t < 1$, $0.002 \leq u \leq 0.08$, $0.8 \leq s + t + u \leq 1.1$, $0.8 \leq v \leq 1.2$, $0.8 \leq w \leq 1.2$, $1.8 \leq v + w \leq 2.2$, and $2.5 \leq x \leq 3.2$.

6. The nitride phosphor according to claim 5, wherein, in Formula (I), s, t, and u satisfy $0.94 \leq s + t + u \leq 1.10$.

7. A light emitting device, comprising:

a fluorescent member containing the nitride phosphor according to any one of claims 1 to 6; and
a light emitting element having an emission peak wavelength in a range of 365 nm to 500 nm.

8. The light emitting device according to claim 7, wherein the fluorescent member further contains at least one selected from the group consisting of phosphors having a composition represented by any one of the following Formulae:

$$(Y,Gd,Tb,Lu)_3(Al,Ga)_5O_{12}:Ce \qquad (IIa)$$

$$(Ca,Sr,Ba)_2SiO_4:Eu \qquad (IIb)$$

$$Si_{6-p}Al_pOpN_{8-p}:Eu \ (0 < p \leq 4.2) \qquad (IIc)$$

$$(Ca,Sr)_8MgSi_4O_{16}(F,Cl,Br)_2:Eu \qquad (IId)$$

$$(La,Y,Gd,Lu)_3Si_6N_{11}:Ce \qquad (IIe)$$

$$(Ca,Sr,Ba)_2Si_5N_8:Eu \qquad (IIg)$$

$$(Ca,Sr,Ba)LiAl_3N_4:Eu \qquad (IIh)$$

$$(Ca,Sr,Ba)_{10}(PO_4)_6(F,Cl,Br)_2:Eu \qquad (IIi)$$

9. The light emitting device according to claim 7 or 8, wherein the fluorescent member further contains at least one selected from the group consisting of phosphors having a composition represented by any one of the following Formulae:

$$A^1_c[M^1_{1-b}Mn_bF_d] \qquad (IIj),$$

wherein, $A^1$ contains at least one selected from the group consisting of Li, Na, K, Rb, and Cs; $M^1$ contains at least one of Si or Ge, and optionally further contains at least one element selected from the group consisting of Group 4 elements and Group 14 elements; b satisfies $0 < b < 0.2$; c represents an absolute value of the charge of $[M^1_{1-b}Mn_bF_d]$ ion; and d satisfies $5 < d < 7$;

$$A^2_f[M^2_{1-e}Mn_eF_g] \qquad (IIk),$$

wherein, $A^2$ contains at least one selected from the group consisting of Li, Na, K, Rb, and Cs; $M^2$ contains at least Si and Al, and optionally further contains at least one element selected from the group consisting of Group 4 elements, Group 13 elements, and Group 14 elements; e satisfies $0 < e < 0.2$; f represents an absolute value of the charge of $[M^2_{1-e}Mn_eF_g]$ ion; and g satisfies $5 < g < 7$.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

**EUROPEAN SEARCH REPORT**

Application Number

EP 25 19 9813

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/037727 A1 (DENKA COMPANY LTD [JP]) 16 March 2023 (2023-03-16) * example 1, table 1; the whole document * | 1-9 | INV. C09K11/77 H10H20/851 |
| X,P | & US 2024/400897 A1 (MITANI SHUNSUKE [JP]) 5 December 2024 (2024-12-05) * example 1, table 1 * * the whole document * ----- | 1-9 | |
| X | EP 2 881 447 A1 (SUMITOMO METAL MINING CO [JP]; UNIV TOHOKU [JP]) 10 June 2015 (2015-06-10) * example 1, table 1 * * the whole document * ----- | 1-9 | |
| X | EP 2 500 399 A1 (DENKI KAGAKU KOGYO KK [JP]) 19 September 2012 (2012-09-19) * tables 1 to 7, examples 1 to 6; claim 9 * * the whole document * ----- | 1-9 | |
| X | US 2019/305193 A1 (AOYAGI KENICHI [JP] ET AL) 3 October 2019 (2019-10-03) * claim 2, claim 4, table 1, examples * * the whole document * ----- | 1-9 | TECHNICAL FIELDS SEARCHED (IPC) C09K H01L H10H |

The present search report has been drawn up for all claims

| Place of search | Date of completion of the search | Examiner |
|---|---|---|
| The Hague | 25 November 2025 | Ziegler, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 9813

This annex lists the patent family members relating to the patent documents cited in the above-mentioned European search report.
The members are as contained in the European Patent Office EDP file on
The European Patent Office is in no way liable for these particulars which are merely given for the purpose of information.

25-11-2025

| Patent document cited in search report | | Publication date | Patent family member(s) | | Publication date |
|---|---|---|---|---|---|
| WO 2023037727 | A1 | 16-03-2023 | CN | 117916341 A | 19-04-2024 |
| | | | JP | WO2023037727 A1 | 16-03-2023 |
| | | | KR | 20240051238 A | 19-04-2024 |
| | | | TW | 202328396 A | 16-07-2023 |
| | | | US | 2024400897 A1 | 05-12-2024 |
| | | | WO | 2023037727 A1 | 16-03-2023 |
| EP 2881447 | A1 | 10-06-2015 | EP | 2881447 A1 | 10-06-2015 |
| | | | JP | 5578739 B2 | 27-08-2014 |
| | | | JP | 2014043539 A | 13-03-2014 |
| | | | TW | 201404868 A | 01-02-2014 |
| | | | US | 2015203749 A1 | 23-07-2015 |
| | | | WO | 2014021006 A1 | 06-02-2014 |
| EP 2500399 | A1 | 19-09-2012 | CN | 102639672 A | 15-08-2012 |
| | | | EP | 2500399 A1 | 19-09-2012 |
| | | | JP | 5737693 B2 | 17-06-2015 |
| | | | JP | WO2011058919 A1 | 28-03-2013 |
| | | | KR | 20120091200 A | 17-08-2012 |
| | | | TW | 201125955 A | 01-08-2011 |
| | | | US | 2012228551 A1 | 13-09-2012 |
| | | | WO | 2011058919 A1 | 19-05-2011 |
| US 2019305193 | A1 | 03-10-2019 | US | 2019305193 A1 | 03-10-2019 |
| | | | US | 2020185575 A1 | 11-06-2020 |

EPO FORM P0459

For more details about this annex : see Official Journal of the European Patent Office, No. 12/82

**REFERENCES CITED IN THE DESCRIPTION**

**Patent documents cited in the description**

- JP 2024154149 A
- WO 2023037727 A